(19) **Europäisches Patentamt / European Patent Office / Office européen des brevets**

(11) **EP 4 503 866 A1**

(12) **EUROPEAN PATENT APPLICATION**
published in accordance with Art. 153(4) EPC

(43) Date of publication:
05.02.2025 Bulletin 2025/06

(21) Application number: 23779364.1

(22) Date of filing: 08.03.2023

(51) International Patent Classification (IPC):
$H05K\ 1/03^{(2006.01)}$      $C09J\ 7/38^{(2018.01)}$
$C09J\ 175/04^{(2006.01)}$

(52) Cooperative Patent Classification (CPC):
C08G 18/10; C08G 18/12; C08G 18/4808;
C08G 18/4825; C08G 18/4833; C08G 18/4854;
C09J 7/38; C09J 175/04; H05K 1/03

(86) International application number:
PCT/JP2023/008932

(87) International publication number:
WO 2023/189337 (05.10.2023 Gazette 2023/40)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 30.03.2022 JP 2022056701

(71) Applicant: AGC INC.
Chiyoda-ku,
Tokyo 1008405 (JP)

(72) Inventors:
• KOMINE, Takuya
Tokyo 100-8405 (JP)
• NAKAMURA, Makito
Tokyo 100-8405 (JP)

(74) Representative: Müller-Boré & Partner
Patentanwälte PartG mbB
Friedenheimer Brücke 21
80639 München (DE)

(54) **PASTE CIRCUIT AND WEARABLE DEVICE**

(57) Provided is a paste circuit comprising a circuit pattern and an adhesive agent layer, the paste circuit being excellent in long-lasting of appropriate adhesive force, without causing malfunction of a circuit such as a short circuit or corrosion. The paste circuit of the present invention is a paste circuit comprising a circuit pattern and an adhesive agent layer, in which an adhesive agent constituting the adhesive agent layer comprises a reaction product of a hydroxyl-terminated urethane prepolymer and a curing agent, the hydroxyl-terminated urethane prepolymer is a reaction product of an oxyalkylene polymer A having an average number of hydroxyl groups per molecule of 2.1 to 3.0, an oxyalkylene polymer B having the number of hydroxyl groups per molecule of 1, and a diisocyanate compound, and has a content of ethylene oxide units of 5% by mass or more, and the curing agent comprises a polyisocyanate compound.

[Fig. 1]

## Description

Technical Field

The present invention relates to a paste circuit having a circuit pattern and an adhesive agent layer, and a wearable device provided with the paste circuit.

Background Art

In flexible electronics, a technology for adhering a circuit on a soft flexible substrate has been employed.

For example, PTL 1 describes that a flexible film on which a circuit pattern is formed and an adhesive agent layer consisting of an adhesive agent containing an acrylic-based polymer (acrylic-based adhesive agent) are laminated in a circuit board member.

It has also been proposed that a silicone-based adhesive agent is used in an adhesive agent layer (e.g., see PTL 2).

Citation List

Patent Literature

PTL 1: JP 2004-346106 A
PTL 2: JP 2006-281488 A

Summary of Invention

Technical Problem

For acrylic-based adhesive agents, adhesive agent-containing components such as monomers which remained during polymerization may have caused a short circuit and corrosion of a circuit. In addition, for example, there has been a problem in that, when an adhesive agent layer is formed on a support having moisture permeability and air permeability, discoloration occurs on a contact surface between a circuit and the support, or the like.

Silicone-based adhesive agents have also had a problem in that malfunction of a circuit similar to that occurred with acrylic-based adhesive agents occurs due to the volatilization of low molecular siloxane.

The present invention is directed to solve problems as mentioned above, and aims to provide a paste circuit having a circuit pattern and an adhesive agent layer, the paste circuit being excellent in long-lasting of appropriate adhesive force, without causing malfunction of a circuit such as a short circuit or corrosion.

Solution to Problem

The present invention is based on the findings that when an adhesive agent layer of a paste circuit is formed of a predetermined polyurethane-based adhesive agent, the long-lasting of its appropriate adhesive force is excellent, without causing malfunction of a circuit such as a short circuit or corrosion.

The present invention provides the following means.

[1] A paste circuit comprising a circuit pattern and an adhesive agent layer, in which an adhesive agent constituting the adhesive agent layer comprises a reaction product of a hydroxyl-terminated urethane prepolymer and a curing agent, the hydroxyl-terminated urethane prepolymer is a reaction product of an oxyalkylene polymer A having an average number of hydroxyl groups per molecule of 2.1 to 3.0, an oxyalkylene polymer B having the number of hydroxyl groups per molecule of 1, and a diisocyanate compound, and has a content of ethylene oxide units of 5% by mass or more, and the curing agent comprises a polyisocyanate compound.

[2] The paste circuit according to [1], in which the number-average molecular weight of the oxyalkylene polymer B is 3500 or more.

[3] The paste circuit according to [1] or [2], in which an oxyalkylene polymer A1 having the number of hydroxyl groups per molecule of 3 is 20 parts by mass or more, out of a total of 100 parts by mass of the oxyalkylene polymer A.

[4] The paste circuit according to any of [1] to [3], in which the oxyalkylene polymer A has a content of ethylene oxide units of 10% by mass or more.

[5] The paste circuit according to any of [1] to [4], in which an amount of the polymer A blended is 10 to 95 parts by mass out of a total of 100 parts by mass of the polymer A and the polymer B.

[6] The paste circuit according to any of [1] to [5], in which the polyisocyanate compound comprises 3 or more isocyanate groups in a molecule.

[7] The paste circuit according to any of [1] to [6], in which the adhesive agent layer has a thickness of 5 to 100 μm.

[8] The paste circuit according to any of [1] to [7], in which the adhesive agent layer has a moisture permeability rate of 3000 g/(m$^2$·day) or more.

[9] The paste circuit according to any of [1] to [8], in which the adhesive agent layer is formed on a main surface of a sheet-shaped support.

[10] The paste circuit according to [9], in which the adhesive agent layer is formed on one main surface of the support, and the circuit pattern is formed on the other main surface of the support.

[11] The paste circuit according to any of [1] to [10], in which the circuit pattern is formed of conductive ink.

[12] A wearable device provided with the paste circuit according to any of [1] to [11].

Advantageous Effects of Invention

The present invention can provide a paste circuit having a circuit pattern and an adhesive agent layer, the paste circuit being excellent in long-lasting of appropriate adhesive force, without causing malfunction of a circuit such as a short circuit or corrosion.

The paste circuit of the present invention is suitable for a flexible device, and since the adhesive agent layer has a low load against the skin, and may exhibit good fixation of a circuit or the like, the paste circuit can suitably be applied to a wearable device.

Brief Description of Drawings

[Fig. 1] Fig. 1 is a schematic cross-sectional view of a paste circuit according to a first embodiment of the present invention.

[Fig. 2] Fig. 2 is a schematic cross-sectional view of a paste circuit according to a second embodiment of the present invention.

[Fig. 3] Fig. 3 is a schematic cross-sectional view of a paste circuit according to a third embodiment of the present invention.

[Fig. 4] Fig. 4 is a schematic cross-sectional view of a paste circuit according to a fourth embodiment of the present invention.

[Fig. 5] Fig. 5 is a schematic cross-sectional view of a paste circuit according to a fifth embodiment of the present invention.

[Fig. 6] Fig. 6 is a schematic cross-sectional view of a paste circuit according to a sixth embodiment of the present invention.

Description of Embodiments

The definitions and meanings of the terms and notations described herein are shown in the followings.

The number-average molecular weight (Mn) and weight-average molecular weight (Mw) are polystyrene equivalent molecular weights determined by measuring with gel permeation chromatography (GPC) based on calibration curves created by using standard polystyrene samples.

The molecular weight in terms of hydroxyl value is a value calculated from the formula of $56100 \times$ (the number of hydroxyl groups in a molecule)/(hydroxyl value [mgKOH/g]).

The hydroxyl value is determined by measurement in accordance with JIS K 1557:2007-1.

The degree of unsaturation is determined by measurement in accordance with JIS K 1557-3:2007.

The isocyanate index indicates an equivalent ratio of isocyanate groups to be reacted and active hydrogen-containing groups (e.g., hydroxyl group) ([isocyanate group]/[active hydrogen-containing groups]), expressed as percentage.

The moisture permeability rate is determined by measurement in accordance with JIS Z 0208:1976 (cup method). Specifically, it is measured by the methods described in Examples.

The paste circuit of the present invention is a paste circuit comprising a circuit pattern and an adhesive agent layer, in which an adhesive agent constituting the adhesive agent layer comprises a reaction product of a predetermined hydroxyl-terminated urethane prepolymer and a curing agent.

The hydroxyl-terminated urethane prepolymer is a reaction product of an oxyalkylene polymer A having an average number of hydroxyl groups per molecule of 2.1 to 3.0 (hereinafter, also simply referred to as "polymer A"), an oxyalkylene polymer B having the number of hydroxyl groups per molecule of 1 (hereinafter, also simply referred to as "polymer B"), and a polyisocyanate compound, and has a content of ethylene oxide (EO) units of 5% by mass or more. In addition, the curing agent comprises a polyisocyanate compound.

By forming an adhesive agent layer of a predetermined polyurethane-based adhesive agent as described above, the paste circuit being excellent in long-lasting of appropriate adhesive force can be constituted, without causing malfunction of a circuit such as a short circuit or corrosion.

[Adhesive Agent Layer]

An adhesive agent layer is formed of an adhesive agent comprising a reaction product of a predetermined hydroxyl-terminated urethane prepolymer and a curing agent. Such a polyurethane-based adhesive agent formed from a urethane prepolymer is suitable for a paste circuit from the viewpoint of circuit formation and adhesive force.

The adhesive agent layer is formed by applying or pasting to a support, which is a constituent member of an adhesive sheet, a circuit pattern, or a substrate of a circuit pattern, in an embodiment of a paste circuit to be described later.

(Hydroxyl-Terminated Urethane Prepolymer)

The hydroxyl-terminated urethane prepolymer of the present invention is a reaction product of a polymer A, a polymer B, and a diisocyanate compound. In the reaction product, the hydroxyl groups of the polymer A and the polymer B react with the isocyanate group of the diisocyanate compound to form a urethane bond, and unreacted hydroxyl groups correspond to terminal hydroxyl groups of the hydroxyl-terminated urethane prepolymer.

The hydroxyl-terminated urethane prepolymer has a content of EO units of 5% by mass or more, preferably 10 to 80% by mass, and more preferably 12 to 50% by mass. When the content of EO units in the hydroxyl-terminated urethane prepolymer falls within the above range, it is easy to obtain an adhesive agent layer having good adhesive force that has a low load against the skin and exhibits good fixation of a circuit or the like.

The EO units in the hydroxyl-terminated urethane prepolymer are derived from EO units constituting the polymer A and EO units constituting the polymer B, and the content can be determined by analyzing the monomer composition of oxyalkylene chains in the hydroxyl-terminated urethane prepolymer through measurement of $^{13}$C-NMR (nuclear magnetic resonance).

Note that the content of EO units in the adhesive agent layer can be determined through the measurement of $^{13}$C-NMR as in the case of the content of EO units in the hydroxyl-terminated urethane prepolymer, and is preferably 5% by mass or more, more preferably 10 to 80% by mass, and further more preferably 12 to 50% by mass, from the viewpoint of having a good moisture permeability rate, a low load against the skin and good fixation of a circuit or the like.

<Oxyalkylene Polymer A>

The average number of hydroxyl groups per molecule of the oxyalkylene polymer A is 2.1 to 3.0, preferably 2.2 to 2.9, and more preferably 2.3 to 2.8.

When the average number of hydroxyl groups of the polymer A falls within the above range, it is easy to obtain an adhesive agent layer having good adhesive force that has a good moisture permeability rate, does not leave adhesive residues, has a low load against the skin, and exhibits good fixation of a circuit or the like.

The average number of hydroxyl groups per molecule of the polymer A can be calculated by the hydroxyl value of the polymer A and the measured value of Mn, using the formula of the hydroxyl value $\times$ Mn/56100.

The polymer A may be one oxyalkylene polymer, or two or more oxyalkylene polymers. When the polymer A consists of two or more oxyalkylene polymers, good adhesive force of the adhesive agent layer is easily adjusted.

The polymer A may consist of, for example, an oxyalkylene polymer A1 having the number of hydroxyl groups per molecule of 3 (hereinafter, also simply referred to as "polymer A1"), and an oxyalkylene polymer A2 having the number of hydroxyl groups per molecule of 2 (hereinafter, also simply referred to as "polymer A2"). In addition, the component of the polymer A may be an oxyalkylene polymer having the number of hydroxyl groups per molecule of 4 or more, as long as the average number of hydroxyl groups per molecule is 2.1 to 3.0.

Note that when the polymer A consists of the polymer A1 and the polymer A2, the weight-averaged value of the number of hydroxyl groups per molecule of the polymer A1 and the number of hydroxyl groups per molecule of the polymer A2 based on the composition ratio (amount blended) of the polymer A1 and the polymer A2 can be considered as the average number of hydroxyl groups of the polymer A.

Out of a total of 100 parts by mass of the polymer A, the polymer A1 accounts for preferably 20 parts by mass or more, more preferably 25 to 95 parts by mass, and further preferably 30 to 90 parts by mass, from the viewpoint of good adhesive force, less adhesive residues, and the like of the adhesive agent layer.

The polymer A has Mn of preferably 21000 to 50000, more preferably 5000 to 30000, and further preferably 8000 to 25000, from the viewpoint of good flexibility, good adhesive force, less adhesive residues, and the like of the adhesive agent layer.

Mw/Mn of the polymer A is closed to 1, and preferably less than 1.20, more preferably less than 1.13, and further preferably less than 1.10, since the narrower the molecular weight distribution, the less likely the hydroxyl-terminated urethane prepolymer becomes high viscous, leading to increased synthesis efficiency.

In addition, the degree of unsaturation of the polymer A is preferably 0.020 meq/g or less, more preferably 0.018 meq/g or less, and further preferably 0.015 meq/g or less, and it is preferable to be closer to 0 meq/g, from the viewpoint of good curability of the hydroxyl-terminated urethane prepolymer, less adhesive residues of the adhesive agent layer, and the like.

When the polymer A consists of two or more oxyalkylene polymers, each of the oxyalkylene polymers preferably falls within the above Mn, Mw/Mn, and degree of unsaturation.

The synthesis method of the polymer A is not particularly limited, and for example, the polymer A can be obtained by ring-opening addition polymerization of a compound having a cyclic ether structure, preferably alkylene oxide, to an initiator having two or more active hydrogens in the presence of a catalyst. When the polymer A consists of the polymer A1 and the polymer A2, a method can be used in which the ring-opening addition polymerization of a compound having a cyclic ether structure is carried out by concurrently using an initiator having three active hydrogens and an initiator having two active hydrogens to simultaneously generate the polymer A1 and the polymer A2. From the viewpoint of adjusting the amount of the polymer A1 blended and the polymer A2 more precisely, a method is preferable in which the polymer A obtained by the ring-opening addition polymerization of a compound having a cyclic ether structure to an initiator having three active hydrogens and the polymer B obtained by the ring-opening addition polymerization of a compound having a cyclic ether structure to an initiator having two active hydrogens are separately synthesized and then mixed together.

The compound having a cyclic ether structure is preferably linear or branched having 2 to 14 carbon atoms, more preferably 2 to 10 carbon atoms, and further preferably 2 to 4 carbon atoms. The compound having a cyclic ether structure may be used alone, or in combination of two or more.

Examples of the compound having a cyclic ether structure include ethylene oxide (EO), propylene oxide (PO), 1,2-butylene oxide, 2,3-butylene oxide, methyl glycidyl ether, butyl glycidyl ether, 2-ethylhexyl glycidyl ether, lauryl glycidyl ether, hexyl glycidyl ether, and tetrahydrofuran. Among these, EO and PO are preferable.

When two or more compounds having a cyclic ether structure are used in combination, for the polymer A, the sequence of oxyalkylene groups derived from each of the compounds may be random or blocked.

The polymer A preferably contains EO units (oxyethylene groups), more preferably contains 10% by mass or more, further preferably 15 to 60% by mass, and yet further preferably 20 to 50% by mass, from the viewpoint of obtaining an adhesive agent layer that has an appropriate hydrophilicity in consideration of good adhesive force to the skin, and which crystallinity is suppressed.

The content of EO units in the polymer A can be determined by analyzing the monomer composition of oxyalkylene chains in the polymer A through the measurement of $^{13}$C-NMR. For example, when the oxyalkylene chains in the polymer A consist of EO units and PO units, the content of EO units can be calculated based on the area of the peak showing methylene groups of the EO units and the area of the peak showing methyl groups of the PO units.

When the polymer A consists of the polymer A1 and the polymer A2, the same applies to the respective content of EO units in the polymer A1 and the polymer A2.

Note that the content of EO units in the polymer A can be considered as a value obtained by calculating from the amount of ethylene oxide blended in a raw material for synthesis of the polymer A. When the polymer A consists of the polymer A1 and the polymer A2, the weight-averaged value of the content of EO units of the polymer A1 and the content of EO units of the polymer A2 based on the composition ratio (amount blended) of the polymer A1 and the polymer A2 can be considered as the content of EO units of the polymer A.

Examples of the group having an active hydrogen in the initiator include hydroxyl groups, carboxy groups, and amino groups having a hydrogen atom bound to a nitrogen atom. Among these, the hydroxyl group is preferable, and the alcoholic hydroxyl group is more preferable.

Examples of the initiator having three hydroxyl groups include glycerin, trimethylolethane, trimethylolpropane, and 1,2,6-hexanetriol. Any one of these may be used alone, or two or more may be used in combination.

Examples of the initiator having two hydroxyl groups include ethylene glycol, diethylene glycol, propylene glycol, and dipropylene glycol. Any one of these may be used alone, or two or more may be used in combination.

The number of active hydrogens of the initiator generally corresponds to the number of hydroxyl groups per molecule of the oxyalkylene polymer. The polymer A1 can be synthesized, for example, by using glycerin as the initiator. Also, the polymer A2 can be synthesized, for example, by using propylene glycol as the initiator.

Note that the type and amount of the initiator used as a raw material for synthesis of the oxyalkylene polymer can be identified through the measurement of $^{13}$C-NMR. When the polymer A consists of the polymer A1 and the polymer A2, the ratio of the polymer A1 to the polymer A2 is determined by determining the content ratio of the oxyalkylene groups, such as the EO units and PO units, bound to each initiator, from the information on the type and amount of the initiator for the polymer A through the measurement of $^{13}$C-NMR.

The ring-opening addition polymerization can be performed by using a known catalyst, for example, alkali catalysts such as potassium hydroxide, transition metal compound-porphyrin complex catalysts such as a complex obtained by reacting an organic aluminum compound with porphyrin, double metal cyanide complex catalysts, and catalysts consisting of a phosphazene compound. Among these catalysts, the double metal cyanide complex (DMC) catalyst is preferable, since an oxyalkylene polymer having narrow molecular weight distribution and relatively low viscosity is easily obtained. As the double metal cyanide complex include, a known compound can be used, and examples thereof include a zinc hexacyanocobaltate complex with tert-butanol as the ligand.

The synthesis of the oxyalkylene polymer by the ring-opening addition polymerization using a DMC catalyst can be performed by a known method, and for example, a production method described in WO 2003/062301, WO 2004/067633, JP 2004-269776 A, JP 2005-15786 A, WO 2013-065802, and JP 2015-10162 A can be applied.

<Oxyalkylene Polymer B>

The number of hydroxyl groups per molecule of the oxyalkylene polymer B is 1. The polymer B may be one oxyalkylene polymer, or two or more oxyalkylene polymers.

The number of hydroxyl groups of the polymer B can be confirmed by identifying the type and amount of the initiator used as a raw material through the measurement of $^{13}$C-NMR as in the case of the polymer A.

The polymer B has Mn of preferably 3500 or more, more preferably 4000 to 50000, and further preferably 4500 to 30000, from the viewpoint of good flexibility, good followability when pasting on the skin, and the like of the adhesive agent layer.

Mw/Mn of the polymer B is closed to 1, and preferably less than 1.20, more preferably less than 1.13, and further preferably less than 1.10, since the narrower the molecular weight distribution, the less likely the hydroxyl-terminated urethane prepolymer becomes high viscous, leading to increased synthesis efficiency.

In addition, the degree of unsaturation of the polymer B is preferably 0.015 meq/g or less, more preferably 0.013 meq/g or less, and further preferably 0.010 meq/g or less, and it is preferable to be closer to 0 meq/g, from the viewpoint of good curability of the hydroxyl-terminated urethane prepolymer, less adhesive residues of the adhesive agent layer, and the like.

When the polymer B consists of two or more oxyalkylene polymers, each of the oxyalkylene polymers preferably falls within the above Mn, Mw/Mn, and degree of unsaturation.

The synthesis method of the polymer B is not particularly limited, and for example, the polymer B can be obtained by ring-opening addition polymerization of a compound having a cyclic ether structure, preferably alkylene oxide, to an initiator having one active hydrogen in the presence of a catalyst.

The compound having a cyclic ether structure is similar to those described for the polymer A. PO alone, or EO and PO in combination is preferable.

The polymer B preferably contains EO units of 0 to 80% by mass, more preferably 0 to 60% by mass, and further preferably 0 to 50% by mass, from the viewpoint of obtaining an adhesive agent layer that has an appropriate moisture permeability rate in consideration of good adhesive force to the skin, and which crystallinity is suppressed.

The content of EO units in the polymer B can be determined as in the case of the polymer A.

The group having an active hydrogen in the initiator includes those similar to the case of the polymer A, and the hydroxyl group is preferable, and the alcoholic hydroxyl group is more preferable.

The initiator having one hydroxyl group is preferably a monohydric alcohol having 2 to 4 carbon atoms, from the viewpoint of ease of availability, and the like; examples thereof include n-propanol, isopanol, n-butanol, sec-butanol, isobutanol, and tert-butanol, and among these, n-butanol, sec-butanol, isobutanol, and tert-butanol are preferable. One initiator may be used alone, or two or more may be used in combination.

The ring-opening addition polymerization can be performed by a known method as in the case of the polymer A.

<Diisocyanate Compound>

The diisocyanate compound used for synthesis of the hydroxyl-terminated urethane prepolymer is an organic compound having 2 isocyanate groups in a molecule. One diisocyanate compound may be used alone, or two or more may be used in combination.

The diisocyanate compound may be an aliphatic diisocyanate compound, either linear or branched, and examples thereof include tetramethylene diisocyanate, hexamethylene diisocyanate (HDI), dodecamethylene diisocyanate, 2,2,4-trimethylhexamethylene diisocyanate, 2,4,4-trimethylhexamethylene diisocyanate, lysine diisocyanate, 2-methylpentane-1,5-diisocyanate, and 3-methylpentane-1,5-diisocyanate.

Also, as an alicyclic diisocyanate compound, examples thereof include isophorone diisocyanate (IPDI), hydrogenated xylylene diisocyanate, 4,4'-dicyclohexylmethane diisocyanate (HMDI), 1,4-cyclohexane diisocyanate, methylcyclohexylene diisocyanate, and 1,3-bis(isocyanatomethyl)cyclohexane.

Further, as an aromatic diisocyanate compound, examples thereof include tolylene diisocyanate, 2,2'-diphenylmethane diisocyanate, 2,4'-diphenylmethane diisocyanate, 4,4'-diphenylmethane diisocyanate (MDI), 4,4'-dibenzyl diisocyanate, 1,5-naphthylene diisocyanate, 1,3-phenylene diisocyanate, 1,4-phenylene diisocyanate, dialkyl diphenylmethane diisocyanate, and tetraalkyl diphenylmethane diisocyanate.

In addition, as an aromatic aliphatic diisocyanate compound, examples thereof include xylylene diisocyanate, and tetramethylxylylene diisocyanate (TMXDI).

Among these, HDI, IPDI, HMDI, and TMXDI are preferable, and HDI is more preferable from the viewpoint of obtaining an adhesive agent layer having high glass transition temperature, good tensile strength, and elongation at break.

Furthermore, as the diisocyanate compound, a bi-functional isocyanate-terminated urethane prepolymer obtained by previously reacting the diisocyanate compound as described above with diol (e.g., ethylene glycol, propylene glycol, 1,4-butanediol, 1,5-pentanediol, 3-methyl-1,5-pentanediol, and 1,6-hexanediol) can be used.

<Synthesis Method>

The hydroxyl-terminated urethane prepolymer can be synthesized, for example, by a method in which the polymer A, the polymer B, and the diisocyanate compound, as well as a catalyst and solvent to be appropriately added thereto as necessary, are charged at once in a reaction vessel, or a method in which the polymer A and the polymer B, as well as a catalyst and solvent to be appropriately added thereto as necessary are charged to a reaction vessel first, and then the diisocyanate compound is subsequently added dropwise or the like thereto. The method of adding the diisocyanate compound is preferable, from the viewpoint of ease of molecular weight distribution control of the hydroxyl-terminated urethane prepolymer due to preferential reaction of low-molecular components in the raw material for synthesis.

As the catalyst, a known urethanization catalyst, for example, a tertiary amine compound, organometallic compound, or the like is used. One catalyst may be used alone, or two or more may be used in combination.

Examples of the tertiary amine compound include triethylamine, triethylenediamine, and 1,8-diazabicyclo [5.4.0]-7-undecene (DBU).

Examples of the organometallic compound include tin compounds such as dibutyltin dichloride, dibutyltin oxide, dibutyltin dibromide, dibutyltin dimaleate, dibutyltin dilaurate (DBTDL), dibutyltin diacetate, dibutyltin sulfide, tributyltin sulfide, tributyltin oxide, tributyltin acetate, triethyltin ethoxide, tributyltin ethoxide, dioctyltin oxide, tributyltin chloride, tributyltin trichloroacetate, and tin 2-ethylhexanoate; titanium compounds such as dibutyltitanium dichloride, tetrabutyltitanate, and butoxytitanium trichloride; lead compounds such as lead oleate, lead 2-ethylhexanoate, lead benzoate, and lead naphthenate; iron compounds such as iron 2-ethylhexanoate, and iron acetylacetonate; cobalt compounds such as cobalt benzoate, and cobalt 2-ethylhexanoate; zinc compounds such as zinc naphthenate, and zinc 2-ethylhexanoate, and zirconium compounds such as zirconium naphthenate.

When using a catalyst, the amount thereof used is preferably 0.001 to 1.0 parts by mass, more preferably 0.002 to 0.5 parts by mass, and further preferably 0.005 to 0.1 parts by mass, based on a total of 100 parts by mass of the polymer A and the polymer B, from the viewpoint of promoting an appropriate urethanization reaction.

Examples of the solvent include ketons such as acetone, and methylethylketon; esters such as ethyl acetate; and aromatic hydrocarbons such as toluene, and xylene. One solvent may be used alone, or two or more may be used in combination.

When using a solvent, the amount thereof used is preferably 50 to 500 parts by mass, more preferably 70 to 400 parts by mass, and further preferably 80 to 300 parts by mass, based on a total of 100 parts by mass of the polymer A and the polymer B, from the viewpoint of uniformity of the reaction systems and synthesis efficiency.

The amount of the polymer A blended is preferably 10 to 95 parts by mass, more preferably 20 to 90 parts by mass, and further preferably 30 to 85 parts by mass, based on a total of 100 parts by mass of the polymer A and the polymer B, from the viewpoint of obtaining an adhesive agent layer having an appropriate moisture permeability rate in consideration of good adhesive force to the skin.

It is preferable that polymer A, the polymer B, and the diisocyanate compound be reacted at the isocyanate index of 100 or less, preferably 30 to 95, and more preferably 50 to 95, from the viewpoint of efficiently obtaining a hydroxyl-terminated urethane prepolymer having an appropriate molecular chain length.

The reaction temperature is preferably less than 100°C, more preferably 70 to 95°C, and further preferably 75 to 95°C, from the viewpoint of promoting the urethanization reaction and suppressing the side reaction.

After completion of the reaction, a terminator for reaction such as acetylacetone may be added thereto in order to quench the catalyst.

The average number of hydroxyl groups per molecule of the hydroxyl-terminated urethane prepolymer is preferably 3.0 or less, more preferably 1.7 to 2.9, and further preferably 1.8 to 2.5, from the viewpoint of obtaining an adhesive agent layer having an appropriate moisture permeability rate in consideration of good adhesive force to the skin.

Note that the average number of hydroxyl groups per molecule of the hydroxyl-terminated urethane prepolymer is considered as the weight-averaged value of the number of hydroxyl groups per molecule of the polymer A and the number of hydroxyl groups per molecule of the polymer B based on the composition ratio (amount blended) of the polymer A and the polymer B.

(Curing Agent)

An adhesive agent constituting the adhesive agent layer can be obtained by reacting the hydroxyl-terminated urethane prepolymer with a curing agent. The curing agent comprises a polyisocyanate compound having 2 or more isocyanate groups in a molecule. One polyisocyanate compound may be used alone, or two or more may be used in combination.

The polyisocyanate compound is preferably a diisocyanate compound, from the viewpoint of ease of availability, reactivity, and the like. In addition, the polyisocyanate compound having 3 or more isocyanate groups in a molecule is preferable, from the viewpoint of good adhesive force, less adhesive residues, and the like of the adhesive agent layer.

Specific examples of the diisocyanate compound include those similar to the specific examples of the diisocyanate compound constituting the hydroxyl-terminated urethane prepolymer, as described above.

Examples of the polyisocyanate compound include isocyanurate modified products (e.g., "Coronate (registered trademark, hereinafter description omitted) HX" (manufactured by Tosoh Corporation)), biuret modified products (e.g., "Duranate (registered trademark) 24A-100" (manufactured by Asahi Kasei Corporation)), allophanate modified products, and trifunctional or higher isocyanate-terminated urethane prepolymers (adducts) which are reaction products of a diisocyanate compound and polyol having 3 or more hydroxyl group in one molecule (e.g., trimethylolpropane) (e.g., "Coronate L", "Coronate L-55E", "Coronate L-45E" (all manufactured by Tosoh Corporation)), all of which are derivatives of the diisocyanate compound described above.

The isocyanate index of the polyisocyanate compound used to react with the hydroxyl-terminated urethane prepolymer is preferably more than 100, more preferably 101 to 1500, and further preferably 105 to 1000.

(Adhesive Agent)

The adhesive agent used to form an adhesive agent layer may be a one-component type in which a hydroxyl-terminated urethane prepolymer and a curing agent are mixed in advance, or a two-component type consisting of a first component that contains a hydroxyl-terminated urethane prepolymer and a second component that contains a curing agent.

For the synthesis of the reaction product of the hydroxyl-terminated urethane prepolymer and the curing agent, a catalyst and a solvent can be used as necessary.

As the catalyst, the above-mentioned urethanization catalysts can be used. Also, when using a catalyst, the amount thereof used is preferably 0.001 to 1.0 parts by mass, more preferably 0.002 to 0.5 parts by mass, and further preferably 0.005 to 0.1 parts by mass, based on a total of 100 parts by mass of the hydroxyl-terminated urethane prepolymer and the curing agent. After completion of the reaction, it is preferable to add a reaction terminator in order to inactivate the catalyst.

As the solvent, those similar to the case of the above-mentioned hydroxyl-terminated urethane prepolymer can be used. When using a solvent, the amount thereof used is preferably 50 to 500 parts by mass, more preferably 70 to 400 parts by mass, and further preferably 80 to 300 parts by mass, based on a total of 100 parts by mass of the hydroxyl-terminated urethane prepolymer and the curing agent.

The reaction temperature is preferably less than 120°C or less, more preferably 40 to 110°C, and further preferably 50 to 100°C, from the viewpoint of promoting the urethanization reaction and suppressing the side reaction.

(Other Components)

The adhesive agent may contain components other than the reaction product of the hydroxyl-terminated urethane prepolymer and the curing agent. Examples of the other components include various additives such as a plasticizer, an antioxidant, an antistatic agent, a filler, an ultraviolet absorber, a light stabilizer, a conductivity imparting agent, and a leveling agent. Also, flux may be contained. These other components in the adhesive agent may be used alone, or two or more may be used in combination, and these can be blended at a content within a range that does not impair the effects of the present invention.

The plasticizer can be selected from the viewpoint of compatibility with other components contained, wettability of the adhesive agent layer to an adherend, and the like, and examples thereof include fatty acid ester and phosphoric acid ester, that have 8 to 30 carbon atoms.

The antioxidant contributes to the suppression of thermal deterioration of the adhesive agent layer, or the like; examples thereof include phenol-based, amine-based, sulfur-based, and phosphorous-based antioxidants, and among these, the phenol-based antioxidant is preferable because of its skin sensitivity.

The antistatic agent contributes to the suppression of damage to the circuit pattern due to electrostatic discharge, and examples thereof include inorganic salts; ionic liquids containing imidazolium ions, pyridinium ions, ammonium ions, or the like; and surfactants.

Examples of the filler include talc, calcium carbonate, and titanium oxide.

Examples of the ultraviolet absorber include benzophenone-based, benzotriazole-based, salicylic acid-based, oxalic acid anilide-based, cyanoacrylate-based, and triazine-based ultraviolet absorbers.

Examples of the light stabilizer include hindered amine-based light stabilizers and ultraviolet stabilizers.

Examples of the conductivity imparting agent include metal microparticles such as silver nanoparticles.

(Moisture Permeability Rate)

The moisture permeability rate of the adhesive agent layer is preferably 3000 $g/(m^2 \cdot day)$ or more, more preferably 3500 $g/(m^2 \cdot day)$ or more, and further more preferably 4000 $g/(m^2 \cdot day)$ or more, from the viewpoint that the adhesive agent layer has a low load against the skin and good adhesive force. The upper limit of the moisture permeability rate is not particularly limited.

Note that the moisture permeability rates in the present invention are values measured in an atmosphere of 40°C and 90% RH, and values when the thickness of the adhesive agent layer is 25 $\mu$m. Specifically, it is measured by the methods described in Examples. In Examples, the moisture permeability rate of an adhesive sheet containing a support for the adhesive agent layer was also compared to the moisture permeability rates of commercially available adhesive sheets.

(Adhesive Force)

When the adhesive force of the adhesive agent layer to the human skin is preferably 0.2 to 1.0 N/15 mm, and more preferably 0.3 to 0.7 N/15 mm, the adhesive agent layer can be said to have a low load against the skin and good adhesive force.

Also, when the adhesive agent layer is adhered to a sealant of the circuit pattern, or the like, for example, when the adhesive force to a phenol resin, which is common material as the sealant, is greater than the adhesive force to the human skin, preferably 2.0 N/15 mm or more, and more preferably 3.0 N/15 mm, the adhesive agent layer can be said to exhibit good fixation of a circuit or the like.

Note that the adhesive force used herein is a value measured by a method in accordance with JIS Z 0237:2009, and specifically, it is measured by the methods described in Examples.

(Storage Modulus)

The storage modulus of the adhesive agent layer at 25°C is preferably $1.0 \times 10^4$ to $5.0 \times 10^5$ Pa, more preferably $2.0 \times 10^4$ to $4.0 \times 10^5$ Pa, and further preferably $3.0 \times 10^4$ to $3.0 \times 10^5$ Pa, from the viewpoint of good adhesive force, less adhesive residues, and the like of the adhesive agent layer specifically on the skin.

From the similar viewpoint, the storage modulus at 80°C is preferably $4.0 \times 10^5$ Pa or less, more preferably $5.0 \times 10^2$ to $3.0 \times 10^5$ Pa, and further preferably $1.0 \times 10^3$ to $6.0 \times 10^4$ Pa.

Note that the storage modulus used herein is a value measured with a dynamic viscoelasticity measuring device (measurement conditions: tensile mode with strain of 1%, temperature range from -80 to 130°C, temperature increase rate of 3°C/min, frequency of 1 Hz, sample: 3 mm in diameter $\times$ 4 cm in length).

[Circuit Pattern]

The circuit pattern is formed with a conductive material, and can be formed by a known method as a method for forming a circuit pattern on a substrate or the like. For example, it is formed by a subtractive method in which a thin metal film is processed into a pattern shape by etching, a full-active method or semi-active method in which resist formation and plating technology are used, a method in which conductive ink (e.g., silver paste, and the like) is used to print into a pattern shape. Among these, the circuit pattern is preferably formed by the method in which conductive ink is used, from the viewpoint of circuit retention and ease of fine circuit formation by applying the adhesive agent of the present invention.

A known material can be applied to the substrate used to form a circuit pattern, and examples thereof include those in which paper or glass fabric is impregnated with a phenol resin or epoxy resin. When producing a flexible paste circuit, for example, films made of polyimide, polyester or the like are preferably used.

[Structure of Paste Circuit]

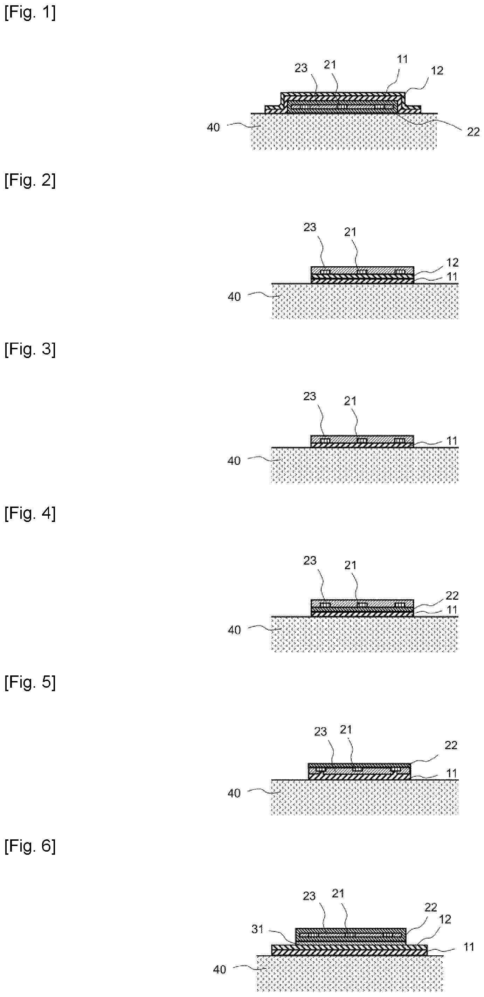

Examples of the embodiment of the paste circuit of the present invention include the structures shown in schematic cross-sectional views of Figs. 1 to 6, but the present invention is not limited to those shown therein. Hereinafter, as a preferred embodiment in which the effects of the present invention are exhibited, an aspect in which the adherend is to be skin will be described; however, the adherend of the paste circuit of the present invention is not limited to the skin, but it can be directed to any solids.

(First Embodiment)

In a paste circuit of a first embodiment shown in Fig. 1, an adhesive sheet is used in which an adhesive agent layer 11 is formed on a main surface of a sheet-shaped support 12. With this adhesive sheet, a circuit pattern 21 and an insulating layer 23 are formed on a substrate in advance to cover a sealed package device 22, and the adhesive agent layer 11 is compression bonded to skin 40 in a state where the package device 22 and the adhesive agent layer 11 on the periphery are in contact with the skin 40, and thereby the paste circuit can be kept sticking on the skin 40.

The support 12 to be used for the adhesive sheet is preferably those having good followability to the shapes of the package device 22, the skin 40, and the like, and made of a material that has sufficient breaking strength even in a thin layer, and examples thereof include a resin film, fabric, paper, or the like. The material for the support 12 may be used alone, or two or more may be used in combination, and also it may be a composite material by laminating layers or the like.

Examples of the material for the resin film include polyurethane; polyamide; acrylic resin; polyolefins such as polyethylene, polypropylene, and ethylene-vinyl acetate copolymer; and polyester. Among these, polyurethane and polyamide are preferable from the viewpoint of good moisture permeability rate.

Examples of the fabric include woven fabric, non-woven fabric, knitted fabric, and net, and the properties of the material may be a resin, which is material for the above-mentioned resin film, natural fibers such as cotton, silk, or wool, and the like.

The thickness of the support 12 is not particularly limited as long as the followability to the shapes of the package device 22, the skin 40, and the like are secured, and sufficient breaking strength is obtained, and examples thereof is 10 to 500 $\mu$m.

The thickness of the adhesive agent layer 11 in the adhesive sheet is preferably 5 to 100 $\mu$m, more preferably 10 to 80 $\mu$m, and further preferably 20 to 50 $\mu$m, from the viewpoint of securing good adhesive force and the moisture permeability rate on the skin.

The surface of the adhesive agent layer 11 in the adhesive sheet is preferably covered with a release liner for the protection of the surface of the adhesive agent layer 11, before pasting on the skin 40.

A known release liner used for adhesive tapes for skin can be applied to the release liner. Examples thereof include woodfree paper, glassine paper, or parchment paper on the surface of which a release agent such as a silicone resin or fluororesin is coated, and woodfree paper anchor coated or polyethylene laminated with resin, on the surface of which a release agent such as a silicone resin or fluororesin is coated.

The release liner is appropriately peeled off from the surface of the adhesive agent layer 11, and the adhesive sheet is used.

(Second Embodiment)

In a paste circuit of a second embodiment shown in Fig. 2, an adhesive sheet similar to that of the first embodiment described above is used, an adhesive agent layer 11 is formed on one main surface of a support 12, and a circuit pattern 21 is formed on the other main surface of the support 12 on the side opposite to the adhesive agent layer 11. In the present embodiment, the support 12 also plays a role as a substrate for the circuit pattern 21, which is advantageous in thinning and flexibility of the paste circuit, the followability to the shape of skin 40, and the like.

In order to form the circuit pattern 21 directly on the surface of the support 12, the method using conductive ink (e.g., silver paste, and the like) to print is more preferable, among the methods of forming the circuit pattern described above.

In Fig. 2, the circuit pattern 21 on the support 12 is covered with an insulating layer 23, but the insulating layer 23 may not be formed depending on the intended use of the paste circuit. The method for forming the insulating layer 23 is not particularly limited, and examples thereof include coating with solder resist.

(Third Embodiment)

In a paste circuit of a third embodiment shown in Fig. 3, a circuit pattern 21 is formed on a surface of an adhesive agent layer 11. In the present embodiment, since the support 12 is not used, it is more advantageous than the first and second embodiments, in thinning and flexibility of the paste circuit, the followability to the shape of skin 40, and the like.

In addition, when the adhesive agent layer 11 has conductivity, the paste circuit of the present embodiment can be applied with the circuit pattern 21 and skin 40 in a conductive state.

In order to form the circuit pattern 21 directly on the surface of the adhesive agent layer 11, the method using conductive ink (e.g., silver paste, and the like) to print is more preferable, among the methods of forming the circuit pattern described above.

Since the adhesive agent layer 11 in the present embodiment is not formed on the support 12, both surface thereof are preferably covered with the above described release liner for the protection of the surfaces of the adhesive agent layer 11, before forming the circuit pattern 21 and pasting on the skin 40. The adhesive agent layer 11 formed in this manner without use of the support 12 is referred to as adhesive transfer sheet. The release liner is appropriately peeled off from the surface of the adhesive agent layer 11, and the adhesive transfer sheet is used.

In Fig. 3, the circuit pattern 21 on the adhesive agent layer 11 is covered with an insulating layer 23, but the insulating layer 23 may not be formed depending on the intended use of the paste circuit. The method for forming the insulating layer 23 is similar to that in the second embodiment described above.

(Fourth Embodiment)

In a paste circuit of a fourth embodiment shown in Fig. 4, the substrate 22 on which the circuit pattern 21 is formed is adhered to the surface of the adhesive agent layer 11, on the side opposite to the circuit pattern 21. Unlike the first embodiment, the paste circuit can be kept sticking on the skin 40 by compression bonding the adhesive agent layer 11 on the skin 40 using the above mentioned adhesive transfer sheet, without bringing the circuit board in which the circuit pattern 21 is formed on the substrate 22 in advance into direct contact with the skin 40.

In Fig. 4, the circuit pattern 21 on the substrate 22 is covered with an insulating layer 23, but the insulating layer 23 may not be formed depending on the intended use of the paste circuit. The method for forming the insulating layer 23 is similar to that in the second embodiment described above.

(Fifth Embodiment)

In a paste circuit of a fifth embodiment shown in Fig. 5, the circuit pattern 21 formed on the substrate 22 is adhered to the surface of the adhesive agent layer 11, on the side opposite to the substrate 22.

When the adhesive agent layer 11 has conductivity, the paste circuit of the present embodiment can be applied with the circuit pattern 21 and skin 40 in a conductive state in the same manner as in the second embodiment.

In Fig. 5, the circuit pattern 21 on the substrate 22 (shown on the lower side in the Figure) is covered with an insulating layer 23, but the insulating layer 23 may not be formed depending on the intended use of the paste circuit. The method for forming the insulating layer 23 is similar to that in the second embodiment described above.

In addition, the insulating layer 23 is not limited to the case of covering all of the circuit pattern 21, and as shown in Fig. 5, it may cover a part thereof. When the adhesive agent layer 11 has conductivity, the paste circuit of such an aspect can be applied such that the circuit pattern 21 is partially conducted with the skin 40 via the adhesive agent layer 11.

(Sixth Embodiment)

In a paste circuit of a sixth embodiment shown in Fig. 6, an adhesive sheet similar to that of the first embodiment described above is used, an adhesive agent layer 11 is formed on one main surface of a support 12, and a package device 22 similar to that of the first embodiment is adhered on the other main surface of the support 12 on the side opposite to the adhesive agent layer 11 with another adhesive agent layer 31. Unlike the first embodiment, the paste circuit of the present embodiment can be kept sticking on skin 40 in a state where only the adhesive agent layer 11 is in contact with the skin 40, without bringing the circuit pattern 21 sealed as the package device 22 into contact with the skin 40.

The another adhesive agent layer 31 is not particularly limited as long as it has adhesive force sufficient to fix the package device 22 on the main surface of the support 12, and known adhesive, double-sided tape, or the like can be applied, or the same material as that of the adhesive agent layer 11 may be used.

[Wearable Device]

When the paste circuit of the present invention described above is used, a wearable device can be suitably provided in which the adhesive agent layer has a low load against the skin, can be continuously kept sticking on for a long period of time such as several days or more without causing skin abnormalities, and exhibits good fixation of a circuit or the like.

Examples of the wearable device to be kept sticking on the skin include biosensors and environmental sensors, and examples of detection items of the biosensors include electrocardiography, pulse wave, body temperature, acceleration, heartbeat interval, pulse interval, respiration interval, electrocardiogram, electromyogram, activity level, blood pressure, body temperature, and electroencephalogram.

Examples

Hereinafter, the present invention will be specifically described based on Examples; however, the present invention is not limited to the following Examples, and various modifications can be made without departing from the scope of the present invention.

[Measuring Methods]

Methods for measuring various physical properties in the following Synthesis Examples and production examples are as follows.

(Hydroxyl Value)

The hydroxyl value V was determined in accordance with B method (automatic potentiometric titration method) of JIS K 1557-1:2007.

(Molecular Weight in Terms of Hydroxyl Value)

The molecular weight in terms of hydroxyl value $M_{OHV}$ was calculated by the following formula, from the hydroxyl value OHV [mgKOH/g] determined above.

$$M_{OHV} = 56.1 \times 1000 \times x/OHV$$

wherein 56.1 represents the molecular weight of potassium hydroxide. x represents the number of hydroxyl groups per molecule of the oxyalkylene polymer, and the number of hydroxyl groups per molecule of the initiator used for the synthesis of the oxyalkylene polymer was considered as x.

(Number-Average Molecular Weight (Mn) and Weight-Average Molecular Weight (Mw))

Mn and Mw were measured with gel permeation chromatography (GPC) in the following measurement conditions (in terms of polystyrene), the molecular weight distribution (Mw/Mn) was calculated from these values.

[Measurement Conditions]

- Apparatus used: "HLC-8320GPC", manufactured by Tosoh Corporation
- Column used: "TSKgel (registered trademark) SuperMultiporeHZ-M", manufactured by Tosoh Corporation
- Detector: Differential refractive index (RI) detector
- Detected temperature: 40°C
- Eluent: Tetrahydrofuran
- Flow rate: 0.350 mL/min
- Sample concentration: 0.5% by mass
- Amount of sample infused: 10 μL
- Standard sample: Polystyrene

(Content of Ethylene Oxide (EO) Units)

The content of EO units of the oxyalkylene polymer was based on the amount of PO and EO charged used for the synthesis, and the amount of EO charged was considered as the content of EO units in the oxyalkylene polymer.
The content of EO units of the hydroxyl-terminated urethane prepolymer was designated as the weight-averaged value of the content of EO units in each component of the raw material.

(Degree of unsaturation)

The degree of unsaturation was measured in accordance with JIS K 1557-3:2007.

(Average Number of Hydroxyl Groups Per Molecule of Oxyalkylene Polymer A)

The number of hydroxyl groups per molecule of each of the oxyalkylene polymers A1 and A2 used as the oxyalkylene polymer A (the number of hydroxyl groups per molecule of the initiator used for the synthesis) was weight-averaged based on each of the amounts of the oxyalkylene polymers A1 and A2 blended, and the obtained value was considered as the average number of hydroxyl groups per molecule.

(Average Number of Hydroxyl Groups Per Molecule of Hydroxyl-Terminated Urethane Prepolymer)

The number of hydroxyl groups per molecule of each of the oxyalkylene polymers (oxyalkylene polymers A1, A2 and B) used for the synthesis of the hydroxyl-terminated urethane prepolymer was weight-averaged based on each of the amounts of the oxyalkylene polymers blended, and the obtained value was considered as the average number of hydroxyl groups per molecule.

[Substances Used]

Various substances used in the following Synthesis Examples are shown below in detail.

- TBA-DMC catalyst: zinc hexacyanocobaltate complex with tert-butanol as the ligand.
- PO: Propylene oxide
- EO: Ethylene oxide
- Absorbent: Synthesized magnesium silicate; "KYOWAAD (registered trademark) 600S", manufactured by Kyowa Chemical Industry Co., Ltd.
- DBTDL: Dibutyltin dilaurate; manufactured by Tokyo Chemical Industry Co., Ltd.; urethanization catalyst
- HDI: Hexamethylene diisocyanate; "Duranate (registered trademark) 50M-HDI", manufactured by Asahi Kasei Corporation
- Curing agent: Trimethylolpropane-modified tolylene diisocyanate (TMP adduct of TDI); "Coronate L", manufactured by Tosoh Corporation; Solid content of about 75% by mass
- Silver paste: "TR70901", manufactured by TAIYO INK MFG. CO., LTD.

[Synthesis of Oxyalkylene Polymer]

(Synthesis Example 1-1)

In a pressure-proof container, as the initiator, 1000 g of glycerin and TBA-DMC catalyst (metal concentration of 46 ppm by mass) was charged, and after nitrogen substitution in the container, the reaction solution was heated to 135°C while being stirred to react by adding 120g of PO.
The reaction solution was cooled to 135°C after the temperature increase stopped, 3782.4 g of PO and 945.6 g of EO were added into the container while stirring the reaction solution, and then after confirming that there was no more change in inner pressure, the absorbent was added thereto and neutralization and catalyst removal were performed to obtain oxyalkylene polymer A1.

(Synthesis Example 1-2)

Oxyalkylene polymer A2 was synthesized in the same manner as in Synthesis Example 1-1, except that the initiator in Synthesis Example 1-1 was changed from glycerin to propylene glycol.

(Synthesis Example 1-3)

Oxyalkylene polymer B1 was synthesized in the same manner as in Synthesis Example 1-1, except that the initiator in Synthesis Example 1-1 was changed from glycerin to n-butanol, after the reaction solution was cooled, no EO was added but 2364 g of PO was added.
Aspects of each of the oxyalkylene polymers produced in the above Synthesis Examples are shown in the following Table 1.

Table 1

| Synthesis examples | 1-1 | 1-2 | 1-3 |
|---|---|---|---|
| Oxyalkylene polymer | A1 | A2 | B1 |
| The number of hydroxyl groups per molecule | 3 | 2 | 1 |
| Hydroxyl value [mgKOH/g] | 17.6 | 11.8 | 11.5 |
| Mn | 8470 | 9510 | 4900 |
| Mw/Mn | 1.19 | 1.06 | 1.09 |
| The content of EO units [% by mass] | 20 | 20 | 0 |
| Degree of unsaturation [meq/g] | 0.013 | 0.011 | 0.007 |

[Synthesis of Hydroxyl-Terminated Urethane Prepolymer]

(Synthesis Example 2-1)

In a reaction vessel equipped with a thermometer, a stirrer, and a cooling tube, 36 parts by mass of oxyalkylene polymer A1, 48 parts by mass of oxyalkylene polymer A2, 16 parts by mass of oxyalkylene polymer B1, and 50.6 parts by mass of toluene and 50.6 parts by mass of ethyl acetate were charged, 0.006 parts by mass of DBTDL was added, and the mixture was mixed at 40°C, and then 1.69 parts by mass of HDI (isocyanate index of 85) was added thereto to react at 80°C.
The average number of hydroxyl groups per molecule of the blended oxyalkylene polymer A (oxyalkylene polymers A1 and A2) was 2.4.
While appropriately diluting the mixture with ethyl acetate, the mixture was maintained at 80°C and reacted for 7 hours to obtain a solution of transparent hydroxyl-terminated urethane prepolymer with a concentration of 50% by mass (Prepolymer U1; the average number of hydroxyl groups of 2.1, the content of EO units of 17% by mass).

(Synthesis Example 2-2)

In a reaction vessel equipped with a thermometer, a stirrer, and a cooling tube, 30 parts by mass of oxyalkylene polymer A1, 70 parts by mass of oxyalkylene polymer A2, and 50.6 parts by mass of toluene and 50.6 parts by mass of ethyl acetate were charged, 0.006 parts by mass of DBTDL was added, and the mixture was mixed at 40°C, and then 1.69 parts by mass of HDI (isocyanate index of 85) was added thereto to react at 80°C.
The average number of hydroxyl groups per molecule of the blended oxyalkylene polymer A (oxyalkylene polymers A1 and A2) was 2.4.
While appropriately diluting the mixture with ethyl acetate, the mixture was maintained at 80°C and reacted for 7 hours to obtain a solution of transparent hydroxyl-terminated urethane prepolymer with a concentration of 50% by mass (Prepolymer U2; the average number of hydroxyl groups of 2.5, the content of EO units of 20% by mass).

[Production of Adhesive Sheet for Evaluation]

(Production Example 1)

100 parts by mass of Prepolymer U1 solution (concentration of 50% by mass) and 10 parts by mass of the curing agent (isocyanate index of 500) were mixed and deaerated, and then the resulting product was coated on a polyester film (thickness of 50 $\mu$m) as the release liner with a knife coater (dried film thickness of 25 $\mu$m) and dried at 100°C for 3 minutes to form an adhesive agent layer. On the adhesive agent layer, polyester non-woven fabric was adhered as the support (thickness of 70 $\mu$m) and cured in a hot air dryer at 50°C for 3 days to produce Adhesive Sheet S1.

(Production Example 2)

Adhesive Sheet S6 was produced under the same operation as in Production Example 1, except that Prepolymer U1 solution in Production Example 1 (concentration of 50% by mass) was changed to Prepolymer U2 (concentration of 50% by mass).

[Measurement and Evaluation of Adhesive Sheet]

The following various evaluations were conducted for Adhesive Sheet S1 obtained in Production Example 1 (example 1), commercially available adhesive sheet described below (with a release liner) S2 to S5 (examples 2 to 5), and Adhesive Sheet S6 obtained in Production Example 2 (example 6). The evaluation results are shown in Table 2. Note that the example 1 is Example, and examples 2 to 6 are Comparative Examples.

(Adhesive Sheet)

- S2: "Micropore S Surgical Tape", manufactured by 3M Japan Limited, silicone-based adhesive agent, support: polyester non-woven fabric
- S3: "Single Sided Medical Silicone Tape 2476P", manufactured by 3M Japan Limited, silicone-based adhesive agent, support: polyester non-woven fabric
- S4: "Medical Tape 4076", manufactured by 3M Japan Limited, acrylic-based adhesive agent, support: polyester non-woven fabric
- S5: "YU-KI (registered trademark)", manufactured by Nitoms, Inc., acrylic-based adhesive agent, support: polyester non-woven fabric

<Adhesive Force>

(1) Versus Phenol Resin Plate

The adhesive sheet (100 mm high and 15 mm wide) from which the release liner was peeled off was overlapped on the side of the adhesive agent layer with a phenol resin plate ("Sumilite (registered trademark) PL-1102", manufactured by Sumitomo Bakelite Co., Ltd.; 125 mm high, 30 mm wide, 2 mm thick), and a rubber roller was rolled over thereon from the side of the support of the adhesive sheet with a load of 2 kg and a rate of 300 mm/minute for one return to compression bond the adhesive agent layer to the phenol resin plate.
After leaving still for 20 minutes, the adhesive force was measured by peeling off the adhesive sheet at a peeling angle of 90° and a rate of 300 mm/minute in accordance with JIS Z 0237:2009.
Table 2 also shows the evaluation of the measured adhesive force, based on the following evaluation criteria.

[Evaluation Criteria (Phenol Resin Plate)]

A: 3.0 N/15 mm or more
B: 2.0 N/15 mm or more and less than 3.0 N/15 mm
C: less than 2.0 N/15 mm

When evaluated as evaluation A, it can be said the adhesive force is good against the phenol resin, which is a representative material for the sealant of the circuit pattern, or the like.

(2) Versus Human Skin

The adhesive force was similarly measured for the case where the skin of the forearm of a human (subject) was used as the adherend, instead of the phenol resin plate. Table 2 shows the average value of three measurement values. Note that example 6 did not adhere to the skin.
Table 2 also shows the evaluation of the measured adhesive force, based on the following evaluation criteria.

[Evaluation Criteria (Skin)]

A: 0.2 to 1.0 N/15 mm
B: more than 1.0 N/15 mm
C: less than 0.2 N/15 mm

When evaluated as evaluation A, it can be said the adhesive force is appropriate against the skin. When evaluated as evaluation B, the adhesive force is too strong to peel off, and it may cause pain when peeling off. When evaluated as evaluation C, the adhesive force is too weak and the adhesive agent is easily peeled off or does not adhere.

<Keratin Exfoliation>

In the measurement of the adhesive force (2) described above, a measurement sample of 20 mm high and 15 mm wide was cut off from the adhesive sheet peeled off from the skin, and the keratin exfoliation (amount of protein [mg/cm$^2$]) was measured with "Protein Assay Lowry Kit" (manufactured by NACALAI TESQUE, INC.)

Table 2 also shows the evaluation of the keratin Exfoliation, based on the following evaluation criteria.

[Evaluation Criteria]

A: less than 0.1 mg/cm$^2$
B: 0.1 mg/cm$^2$ or more and less than 0.3 mg/cm$^2$
C: 0.3 mg/cm$^2$ or more

When evaluated as evaluation A, it can be said the load of the adhesive layer on the skin is sufficiently low.

<Long-Term Sticking Property>

In a similar manner to the measurement of the adhesive force (2) described above, the adhesive sheet was compression bonded on the skin of the forearm of a human (subject), and the subject spent daily life (work, shower, sleep, and the like) in this state for up to 14 days. The number of days until the adhesive sheet peels off (long-lasting property) was measured, and whether there was presence or absence of skin abnormalities (redness, itchiness, or the like) was determined at the time of peeling (when the adhesive sheet has been kept sticking on for 14 days, it was peeled off while keeping the angle between the skin of the forearm and the adhesive sheet at 90° by hand).

<Moisture Permeability Rate>

Regarding the adhesive sheet from which the release liner was peeled off, the moisture permeability rate was measured in accordance with JIS Z 0208:1976. Specifically, over a cup filled with about 50 g of desiccant (calcium chloride), a specimen of the adhesive sheet in a round shape with a diameter of about 10 mm larger than the inner diameter of the cup was placed, the cup was screwed using a rubber gasket and a ring to measure in a constant temperature and constant humidity tank in an atmosphere of 40°C and 90% RH. The moisture permeability rate was determined according to the following formula.

$$\text{Moisture permeability rate } [\text{g}/(\text{m}^2 \cdot \text{day})] = W \times 240000/S$$

Wherein, S represents an area of an opening part of the cup (moisture permeability area [cm$^2$]), W represents an increased amount of mass per hour [g/hr] of the specimen.

Table 2 also shows the evaluation of the moisture permeability rate, based on the following evaluation criteria.

[Evaluation Criteria]

A: 1500 g/(m$^2$·day) or more
B: 1000 g/(m$^2$·day) or more and less than 1500 g/(m$^2$·day)
C: less than 1000 g/(m$^2$·day)

When evaluated as evaluation A, it can be said the adhesive sheet has a good moisture permeability rate and sufficiently low load against the skin.

Note that the moisture permeability rate of only the adhesive agent layer of Adhesive Sheet S1 was measured as follows.

The adhesive sheet was produced in the same manner as in Production Example 1, except that a coarse nylon net, which could be considered not to affect the moisture permeability rate (without support), was used instead of the polyester non-woven fabric as the support in Production Example 1. Regarding the specimen in which the release liner has been peeled off from the obtained adhesive sheet (assumed to have no support), the moisture permeability rate was measured in the same manner as in the moisture permeability rate measurement of the above mentioned adhesive agent, and the measured value was considered as the moisture permeability rate of the adhesive agent layer.

As a result, the moisture permeability rate of only the adhesive agent layer of Adhesive Sheet S1 was 4900 $g/(m^2 \cdot day)$.

Table 2

| Example | | 1 | 2 | 3 | 4 | 5 | 6 |
|---|---|---|---|---|---|---|---|
| Adhesive sheet | | S1 | S2 | S3 | S4 | S5 | S6 |
| Adhesive agent layer | | Production Example 1 | Silicone-based | Silicone-based | Acrylic-based | Acrylic-based | Production Example 2 |
| Adhesive force [N/15 mm] (evaluation) | Phenol resin plate | 4.0 (A) | 1.5 (C) | 1.7 (C) | 7.6 (A) | 1.6 (C) | 5.2 (A) |
| | Skin | 0.4 (A) | 0.9 (A) | 1.0 (A) | 1.7 (C) | 0.8 (A) | 0 (B) |
| Keratin exfoliation [mg/cm$^2$] (evaluation) | After 20 minutes | 0.02 (A) | 0.02 (A) | 0.01 (A) | 0.14 (B) | 0.02 (A) | - - |
| | After 24 hours | 0.05 (A) | 0.05 (A) | 0.13 (B) | 0.42 (C) | - - | - - |
| Long-term sticking property | Continuity | >14 days | 7 days | 1 days | 3 days | 6 hours | - |
| | Skin abnormality | Absence | Absence | Presence | Presence | Absence | Absence |
| Moisture permeability rate [g/(m$^2$·day)] (evaluation) | | 2100 (A) | 600 (C) | 800 (C) | 200 (C) | 1600 (A) | 5000 (A) |

[Production of Paste Circuit]

(Example 7)

Adhesive Sheet S7 was produced in the same manner as in Production Example 1, such that the dried film thickness of the adhesive agent layer is set to 100 $\mu$m, and a polyurethane film support (thickness of 20 $\mu$m) was adhered on the obtained adhesive agent layer as the support.

A sheet piece (20 mm high and 70 mm wide) was cut off from Adhesive Sheet S7, and a circuit was formed by using the silver paste on the side of the support for screen printing, and dried at 70 to 80°C for 30 minutes to obtain a paste circuit.

(Examples 8 and 9)

Paste circuits were produced in the same manner in example 7, using Adhesive Sheets S3 and S5.

[Evaluation of Paste Circuit]

Circuit retention for the paste circuits of examples 7 to 9 was evaluated. The evaluation results are shown in Table 3. Note that example 7 is Example, and examples 8 and 9 are Comparative Examples.

<Circuit Retention>

In a similar manner to the measurement of the adhesive force (2) described above, the paste circuit was compression bonded on the skin of the forearm of a human (subject), and the subject spent daily life (without shower) in this state for 1 day. Whether presence or absence of the exfoliation of the circuit, and whether presence or absence of discoloration on the interface between the circuit and the support was determined. Occurring of the discoloration may be mainly caused by corrosion of the circuit.

Table 3

| Example | | 7 | 8 | 9 |
|---|---|---|---|---|
| Adhesive sheet | | S7 | S3 | S5 |
| Adhesive agent layer | | Production Example 1 | Silicone-based | Acrylic-based |
| Circuit retention | Peeled | Absence | Presence | Presence |
| | Discoloration | Absence | Presence | Presence |

As can be seen from the evaluation results shown in Tables 2 and 3, it is considered that the adhesive sheets (S1 and S7) produced by using Prepolymer U1 (hydroxyl-terminated urethane prepolymer) have excellent moisture permeability, exhibit appropriate adhesive force while suppressing the load against the skin, and also have excellent adhesion to electronic devices and the like so as to enable to suppress malfunction of circuit performance due to exfoliation or corrosion of the circuit, even in the adhesive sheet with the support.

Reference Signs List

11    Adhesive agent layer
12    Support
21    Circuit pattern
22    Substrate (package)
23    Insulating layer
31    Another adhesive agent layer
40    Skin

**Claims**

1.  A paste circuit comprising a circuit pattern and an adhesive agent layer, wherein an adhesive agent constituting the adhesive agent layer comprises a reaction product of a hydroxyl-terminated urethane prepolymer and a curing agent,

    the hydroxyl-terminated urethane prepolymer is a reaction product of an oxyalkylene polymer A having an average number of hydroxyl groups per molecule of 2.1 to 3.0, an oxyalkylene polymer B having the number of hydroxyl groups per molecule of 1, and a diisocyanate compound, and has a content of ethylene oxide units of 5% by mass or more, and
    the curing agent comprises a polyisocyanate compound.

2.  The paste circuit according to claim 1, wherein the number-average molecular weight of the oxyalkylene polymer B is 3500 or more.

3.  The paste circuit according to claim 1 or 2, wherein an oxyalkylene polymer A1 having the number of hydroxyl groups per molecule of 3 is 20 parts by mass or more, out of a total of 100 parts by mass of the oxyalkylene polymer A.

4.  The paste circuit according to any one of claims 1 to 3, wherein the oxyalkylene polymer A has a content of ethylene oxide units of 10% by mass or more.

5.  The paste circuit according to any one of claims 1 to 4, wherein an amount of the polymer A blended is 10 to 95 parts by mass out of a total of 100 parts by mass of the polymer A and the polymer B.

6.  The paste circuit according to any one of claims 1 to 5, wherein the polyisocyanate compound comprises 3 or more isocyanate groups in a molecule.

7.  The paste circuit according to any one of claims 1 to 6, wherein the adhesive agent layer has a thickness of 5 to 100 $\mu$m.

8. The paste circuit according to any one of claims 1 to 7, wherein the adhesive agent layer has a moisture permeability rate of 3000 g/(m$^2$·day) or more.

9. The paste circuit according to any one of claims 1 to 8, wherein the adhesive agent layer is formed on a main surface of a sheet-shaped support.

10. The paste circuit according to claim 9, wherein the adhesive agent layer is formed on one main surface of the support, and the circuit pattern is formed on the other main surface of the support.

11. The paste circuit according to any one of claims 1 to 10, wherein the circuit pattern is formed of conductive ink.

12. A wearable device provided with the paste circuit according to any one of claims 1 to 11.

[Fig. 1]

[Fig. 2]

[Fig. 3]

[Fig. 4]

[Fig. 5]

[Fig. 6]

## INTERNATIONAL SEARCH REPORT

| International application No. |
| --- |
| **PCT/JP2023/008932** |

**A. CLASSIFICATION OF SUBJECT MATTER**

*H05K 1/03*(2006.01)i; *C09J 7/38*(2018.01)i; *C09J 175/04*(2006.01)i
FI: H05K1/03 610H; C09J7/38; C09J175/04

According to International Patent Classification (IPC) or to both national classification and IPC

**B. FIELDS SEARCHED**

Minimum documentation searched (classification system followed by classification symbols)

H05K1/03; C09J7/38; C09J175/04

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2020/175220 A1 (AGC INC ) 03 September 2020 (2020-09-03)<br>paragraphs [0010]-[0125] | 1-10, 12 |
| Y | | 11 |
| Y | WO 2020/090634 A1 (MITSUI CHEMICALS INC) 07 May 2020 (2020-05-07)<br>paragraph [0051] | 11 |
| A | WO 2010/137699 A1 (INOAC TECHNICAL CENTER CO., LTD.) 02 December 2010<br>(2010-12-02) | 1-12 |
| A | JP 2019-214655 A (TOSOH CORP) 19 December 2019 (2019-12-19) | 1-12 |
| A | JP 2017-82113 A (AUTO KAGAKU KOGYO KK) 18 May 2017 (2017-05-18) | 1-12 |
| A | US 2017/0164461 A1 (INTEL CORPORATION) 08 June 2017 (2017-06-08) | 1-12 |

☐ Further documents are listed in the continuation of Box C.   ☑ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **22 May 2023** | **30 May 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

# EP 4 503 866 A1

**INTERNATIONAL SEARCH REPORT**
Information on patent family members

International application No.

**PCT/JP2023/008932**

| Patent document cited in search report | | | Publication date (day/month/year) | Patent family member(s) | | | Publication date (day/month/year) |
|---|---|---|---|---|---|---|---|
| WO | 2020/175220 | A1 | 03 September 2020 | US 2021/0371574 A1 paragraphs [0035]-[0286] EP 3933006 A1 CN 113518813 A | | | |
| WO | 2020/090634 | A1 | 07 May 2020 | US 2022/0002507 A1 paragraph [0056] EP 3876680 A1 CN 112740837 A KR 10-2021-0048535 A TW 202037670 A | | | |
| WO | 2010/137699 | A1 | 02 December 2010 | US 2012/0071808 A1 CN 102448449 A KR 10-2012-0035167 A | | | |
| JP | 2019-214655 | A | 19 December 2019 | (Family: none) | | | |
| JP | 2017-82113 | A | 18 May 2017 | (Family: none) | | | |
| US | 2017/0164461 | A1 | 08 June 2017 | WO 2017/099911 A1 | | | |

Form PCT/ISA/210 (patent family annex) (January 2015)

22

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004346106 A
- JP 2006281488 A
- WO 2003062301 A
- WO 2004067633 A
- JP 2004269776 A
- JP 2005015786 A
- WO 2013065802 A
- JP 2015010162 A